# FASCICULE DE BREVET EUROPEEN

(11) **EP 3 727 943 B1**
(45) Date de publication et mention de la délivrance du brevet: **14.02.2024**
(21) Numéro de dépôt: 18826366.9
(22) Date de dépôt: 21.12.2018
(51) Int. Cl.: B60R 16/02, H01B 5/02, H02G 5/08

(54) **BARRE DE CONNEXION ÉLECTRIQUE POUR ENSEMBLE ÉLECTRIQUE**
ELEKTRISCHE ANSCHLUSSLEISTE FÜR EINE ELEKTRISCHE ANORDNUNG
ELECTRICAL CONNECTION BAR FOR AN ELECTRICAL ASSEMBLY

(30) Priorité: 22.12.2017 FR 1762953
(43) Date de publication de la demande: 28.10.2020
(73) Titulaire: Valeo eAutomotive France SAS, 95800 Cergy (FR)
(72) Inventeur: TRAMET, Guillaume, 78920 ECQUEVILLY (FR); LESCOT, Hubert, 92430 MARNES LA COQUETTE (FR); BEAUDOUX, Benoît, 75013 PARIS (FR); DENIOT, Roger, 78300 POISSY (FR)
(74) Mandataire: Valeo Powertrain Systems
(86) Numéro de dépôt international: PCT/EP2018/086469
(87) Numéro de publication internationale: WO 2019/122283

(56) Documents cités:
- EP-A1- 3 240 159
- CN-A- 103 078 281
- CN-Y- 201 036 041
- FR-A1- 2 942 917
- FR-A1- 3 021 463
- US-A1- 2012 115 340

## Description

### DOMAINE TECHNIQUE ET OBJET DE L'INVENTION

La présente invention se rapporte au domaine des équipements électriques pour véhicules électriques ou hybrides et concerne plus particulièrement une barre de connexion électrique pour un ensemble électrique ainsi qu'un ensemble électrique comprenant au moins une telle barre de connexion électrique.

L'invention vise notamment à permettre une mesure de l'intensité du courant ou des variations de l'intensité du courant circulant dans une borne électrique d'un ensemble électrique d'un véhicule électrique ou hybride, notamment une borne électrique reliée à un potentiel positif ou négatif d'une batterie d'alimentation haute tension.

### ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Plus précisément, afin de commander le moteur électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Dans une solution connue, l'onduleur se présente sous la forme d'un boitier dans lequel sont montés un module électronique de puissance et une unité électronique de contrôle. Le module électronique de puissance comprend un corps comportant des composants électriques par lesquels passe l'énergie alimentant le moteur électrique. L'unité électronique de contrôle comprend des composants électroniques permettant de contrôler les composants électriques du module électronique de puissance.

Une barre de connexion électrique pour l'échange d'énergie électrique entre un équipement électrique et réseau électrique est décrit dans EP3240159.

Dans le cas d'un moteur triphasé, le module électronique de puissance comprend trois connecteurs électriques, dits « connecteurs de phase », permettant de commander le moteur en utilisant trois courants dits « de phase » déphasés deux à deux, par exemple de 120°. Ces courants de phase sont générés par l'onduleur à partir du courant délivré par la batterie haute tension. Pour ce faire, le module électronique de puissance comprend un premier connecteur de batterie, dit « connecteur positif », adapté pour être relié à un potentiel positif de la batterie, et un deuxième connecteur de batterie, dit « connecteur négatif », adapté pour être relié à un potentiel négatif de la batterie d'alimentation haute tension.

L'unité électronique de contrôle commande le module électronique de puissance afin qu'il réalise la conversion du courant continu reçu de la batterie haute tension, définissant une tension continue entre le connecteur positif et le connecteur négatif, en trois courants de phase alternatifs de commande du moteur.

A cette fin, l'unité électronique de contrôle se présente sous la forme d'une carte électronique sur laquelle sont montés des composants électroniques reliés par des pistes électriques et permettant de commander le module électronique de puissance.

Afin de contrôler le fonctionnement de l'onduleur, il peut être nécessaire de mesurer les variations de l'intensité des courants de phase circulant dans les connecteurs de phase ou dans les connecteurs de batterie. Il existe donc le besoin d'une solution simple, fiable et efficace permettant de mesurer ces variations.

### PRESENTATION GENERALE DE L'INVENTION

A cet effet, l'invention concerne tout d'abord une barre de connexion électrique pour un ensemble électrique, ledit ensemble comprenant un module électronique de puissance et une unité électronique de contrôle dudit module électronique de puissance, ledit module électronique de puissance comportant au moins une borne électrique externe. Ladite barre est remarquable en ce qu'elle est destinée à relier électriquement ladite au moins une borne électrique externe à l'unité électronique de contrôle et en ce qu'elle comprend une embase plane et au moins un élément de connexion s'étendant depuis ladite embase et comprenant au moins une portion de fixation conductrice électriquement, s'étendant orthogonalement à l'embase et destinée à être reliée électriquement avec la au moins une borne électrique externe, et au moins une broche de connexion électrique s'étendant depuis un bord de la portion de fixation et comprenant une extrémité de liaison reliée à la portion de fixation, au moins une portion intermédiaire et au moins une extrémité libre reliée à ladite extrémité de liaison par ladite au moins une portion intermédiaire, ladite au moins une extrémité libre étant adaptée pour être connectée électriquement à l'unité électronique de contrôle.

En venant directement en contact avec une surface électriquement conductrice de l'unité électronique de contrôle, la pièce permet de réaliser une mesure de l'intensité du courant ou des variations de l'intensité du courant circulant dans la au moins une borne électrique externe du module électronique de puissance.

L'ensemble électrique est notamment destiné à être monté dans un véhicule automobile et peut par exemple être un onduleur, un chargeur pour batterie électrique de véhicule automobile, un convertisseur DCDC, etc.

Avantageusement, la portion de fixation est plane ou cylindrique.

De préférence, la au moins une borne de connexion externe est une borne de connexion externe à un potentiel positif d'une batterie d'alimentation haute tension.

Dans une forme de réalisation préférée, la barre de connexion électrique comprend trois éléments de connexion s'étendant orthogonalement de l'embase.

Selon une caractéristique de l'invention, la au moins une portion de fixation et la au moins une broche de connexion électrique sont issues de même matière de sorte que l'élément de connexion soit aisé à fabriquer.

Selon une autre caractéristique de l'invention, l'embase et le au moins un élément de connexion sont issus de même matière.

De préférence, la barre de connexion électrique est une pièce monobloc.

De préférence encore, la barre de connexion est métallique afin qu'elle soit aisée à fabriquer et conduise facilement le courant.

De préférence, la barre de connexion est réalisée en cuivre, en acier ou en aluminium, qui sont des métaux présentant une conduction élevée et qui sont aisés à manipuler lors de la fabrication.

Selon une autre caractéristique de l'invention, la barre de connexion est recouverte d'une surface anticorrosion, de préférence composée d'étain et de nickel. Un tel traitement améliore le contact électrique, limite la corrosion du contact électrique et améliore la compatibilité des matériaux (entre l'organe de fixation, la barre de connexion et la borne électrique externe correspondante).

Selon un aspect de l'invention, la portion de fixation délimite un orifice apte à recevoir un organe de fixation de la barre de connexion électrique sur la au moins une borne électrique externe du module électronique de puissance.

De manière avantageuse, la au moins une extrémité libre s'étend orthogonalement au plan de la portion de fixation.

Dans une forme de réalisation, la broche de connexion électrique comprend deux extrémités libres permettant, lorsque la barre est reliée électriquement à l'unité électronique de contrôle, de remplir une fonction d'anti-rotation de ladite barre. Cette fonction est particulièrement utile lors du montage de la barre sur l'unité électronique de contrôle afin d'éviter d'endommager la connexion électrique entre la barre et l'unité électronique de contrôle.

De préférence encore, la au moins une portion intermédiaire de la broche de connexion électrique est au moins en partie courbée afin de permettre à la au moins une extrémité libre de venir en contact avec une surface de connexion électrique de l'unité électronique de contrôle.

De manière avantageuse, l'épaisseur de la portion de fixation est inférieure à 1,5 mm, de préférence de l'ordre de 1 mm, ce qui permet notamment de former aisément la au moins une broche de connexion lors de la fabrication de la barre.

Selon un aspect avantageux de l'invention, la barre de connexion électrique comprend en outre au moins un organe de réception d'un composant électronique, par exemple une résistance de décharge.

Avantageusement, le au moins un organe de réception comprend deux clips d'attache adaptés pour recevoir chacun une branche dudit composant électronique.

Avantageusement encore, le au moins un organe de réception s'étend orthogonalement à l'embase.

L'invention concerne également un ensemble électrique, notamment pour véhicule automobile électrique ou hybride, ledit ensemble électrique comprenant un module électronique de puissance et une unité électronique de contrôle, ledit module électronique de puissance comportant au moins une borne électrique externe. Ledit ensemble électrique est remarquable en ce qu'il comprend au moins une barre de connexion électrique, telle que présentée précédemment, fixée sur ladite au moins une borne électrique externe et reliée électriquement à l'unité électronique de contrôle.

L'ensemble électrique peut par exemple être un onduleur, un chargeur ou un convertisseur DCDC embarqués dans le véhicule.

Selon un aspect de l'invention, la au moins une barre de connexion électrique est montée sur la au moins une borne électrique externe par l'intermédiaire d'au moins un organe de fixation traversant un orifice formé dans la portion de fixation du au moins un élément de connexion de manière à relier électriquement la au moins une barre de connexion électrique et la borne électrique externe du module électronique de puissance.

Avantageusement, la au moins une borne électrique externe et la portion de fixation du au moins un élément de connexion sont superposées et en contact.

Dans une forme de réalisation, la barre de connexion électrique comprend en outre au moins un organe de réception d'une résistance de décharge et au moins une résistance de décharge montée sur ledit organe de réception.

Avantageusement, le au moins un organe de réception comprend deux clips d'attache adaptés pour recevoir chacun une branche de ladite résistance de décharge

Avantageusement encore, le au moins un organe de réception s'étend orthogonalement à l'embase.

L'invention concerne aussi un véhicule électrique ou hybride comprenant une machine électrique, par exemple une machine de motorisation, alimentée par une batterie d'alimentation haute tension via un réseau électrique embarqué haute tension et un ensemble électrique, par exemple un onduleur, tel que présenté précédemment connecté à ladite machine électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 est une vue en perspective d'une forme de réalisation d'un onduleur selon l'invention,
- la figure 2 est une vue partielle en perspective de l'onduleur de la figure 1,
- la figure 3 est une vue partielle rapprochée en perspective d'une forme de réalisation de la barre de connexion électrique selon l'invention,
- la figure 4 est une vue en perspective d'un ensemble formé de la barre de connexion électrique de la figure 3 et d'une deuxième barre de connexion électrique,
- la figure 5 est une autre vue en perspective de l'ensemble de la figure 4,
- la figure 6 est une vue partielle en perspective de l'onduleur de la figure 2 montrant l'ensemble des figures 4 et 5 fixé sur les bornes électriques externes positive et négative du module électronique de puissance,
- la figure 7 est une vue de côté de l'onduleur de la figure 6,
- la figure 8 est une vue partielle rapprochée en perspective de l'onduleur des figures 6 et 7 sur lequel est montée une résistance de décharge.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

Dans l'exemple décrit ci-après, le véhicule comprend notamment une machine électrique, un ensemble électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

L'ensemble électrique selon l'invention est décrit ci-après dans sa mise en oeuvre pour un onduleur, sans toutefois que cela ne limite la portée de la présente invention. On notera ainsi que l'ensemble électrique pourrait être autre chose qu'un onduleur, par exemple un chargeur ou un convertisseur DCDC embarqués dans le véhicule.

Le réseau électrique embarqué basse tension relie la batterie d'alimentation basse tension et la pluralité d'équipements électriques auxiliaires afin que la batterie d'alimentation basse tension alimente lesdits équipements électriques auxiliaires, tels que des calculateurs embarqués, des moteurs de lève-vitres, un système multimédia, etc. La batterie d'alimentation basse tension délivre typiquement par exemple une tension de l'ordre de 12 V, 24 V ou 48 V. La recharge de la batterie basse tension est réalisée à partir de la batterie haute tension via un convertisseur de tension continue en tension continue, appelé communément convertisseur continu-continu.

Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple le réseau électrique alternatif domestique.

La machine électrique est une machine électrique tournante, de préférence destinée à entrainer les roues du véhicule à partir de l'énergie fournie par la batterie d'alimentation haute-tension. Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par la batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

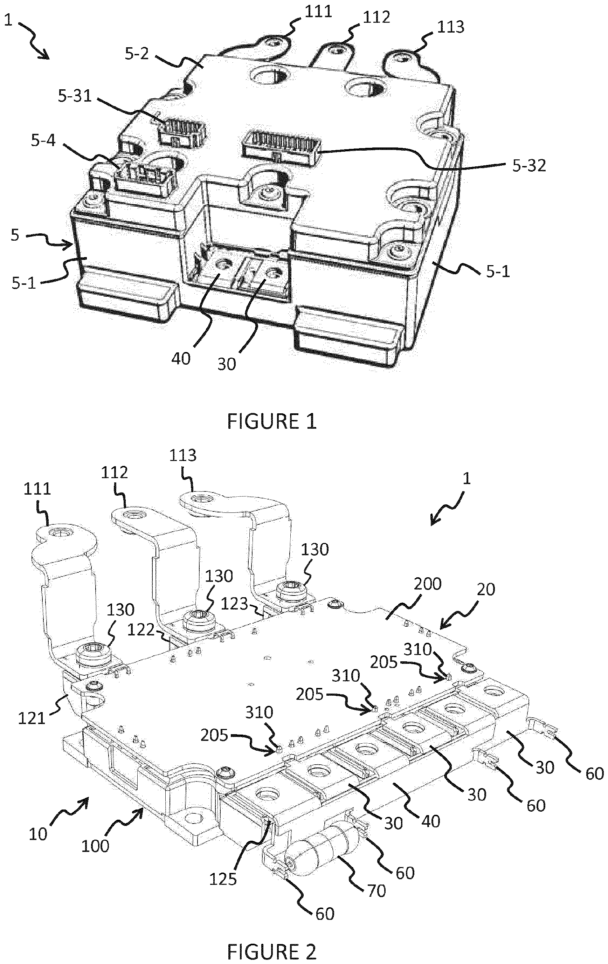

Dans l'exemple illustré à la figure 1, l'onduleur 1 comprend un boitier 5 dans lequel sont montés, en référence à la figure 2, un module électronique de puissance 10 et une unité électronique de contrôle 20.

Comme illustré sur la figure 1, le boitier 5 comprend des parois latérales 5-1 et un couvercle 5-2 monté sur les parois latérales 5-1. Le boitier 5 comprend également une paroi inférieure (non visible sur la figure 1) s'étendant entre les parois latérales 5-1 et qui forme le fond du boitier 5, le module électronique de puissance 10 pouvant être supporté par ledit fond.

Dans l'exemple illustré à la figure 1, l'onduleur 1 comprend de manière non limitative deux connecteurs de signaux 5-31, 5-32 et un connecteur d'alimentation 5-4, montés sur le couvercle 5-2 du boitier 5. Les connecteurs de signaux 5-31, 5-32 sont destinés à permettre un échange de signaux de données entre les composants de l'onduleur 1 et l'extérieur de l'onduleur 1, par exemple avec un contrôleur du véhicule. En particulier, ces connecteurs de signaux 5-31, 5-32 peuvent être connectés à l'unité électronique de contrôle 20. Le connecteur d'alimentation 5-4, est destiné à connecter l'onduleur 1 à un câble d'alimentation électrique, par exemple relié au réseau électrique embarqué basse tension, afin de permettre l'alimentation électrique de l'unité électronique de contrôle 20.

En référence à la figure 2, le module électronique de puissance 10 comprend un corps 100 et une pluralité de connecteurs électriques 30, 40, 111, 112, 113. Plus précisément, dans cet exemple, le module électronique de puissance 10 comprend deux barres 30, 40 de connexion électrique destinées à connecter électriquement l'onduleur 1 à la batterie d'alimentation haute tension, et trois connecteurs de phase 111, 112, 113 destinés à connecter électriquement l'onduleur 1 à la machine électrique.

Notamment, chaque connecteur de phase 111, 112, 113 permet de connecter électriquement une phase de la machine électrique commandée par l'onduleur 1 avec le module électronique de puissance 10. On notera que l'onduleur 1 pourrait comprendre un nombre de connecteurs de phase 111, 112, 113 différent, notamment un nombre fonction du nombre de phases de la machine électrique commandée par l'onduleur 1.

Dans l'exemple illustré à la figure 2, l'onduleur 1 comprend une première barre 30 de connexion électrique, adaptée pour être reliée au potentiel positif de la batterie d'alimentation haute tension, appelée barre 30 de connexion électrique positive, et une deuxième barre 40 de connexion électrique, adaptée pour être reliée au potentiel négatif de la batterie d'alimentation haute tension, appelée barre 40 de connexion électrique négative.

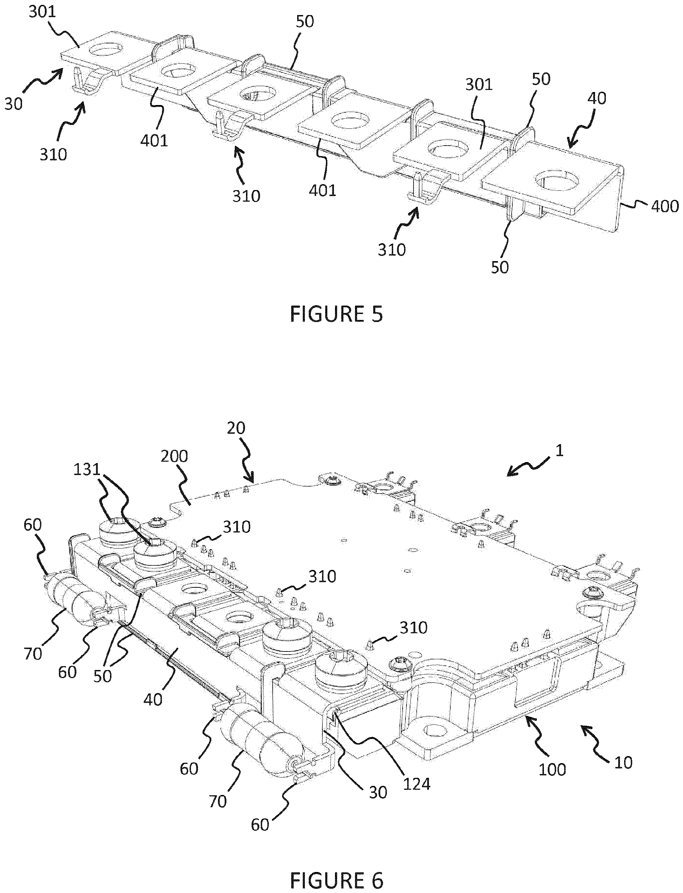

Par ailleurs, le module électronique de puissance 10 comprend des composants électroniques de puissance par lesquels passe l'énergie alimentant la machine électrique, notamment destinés à transformer le courant continu en courants alternatifs ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants électroniques de puissance sont des puces semi-conductrices nues pour lesquels le corps 100 réalise une encapsulation. Dans cet exemple, le module électronique de puissance 10 comprend neuf bornes électriques externes, formant en particulier d'une part trois ports de phase 121, 122, 123 délivrant chacun un courant de phase de commande du moteur et d'autre part trois bornes électriques externes positives 124 (dont une seule est visible sur la figure 6) et trois bornes électriques externes négatives 125 (dont une seule est visible sur la figure 2).

Chaque connecteur de phase 111, 112, 113 permet de relier électriquement ledit port de phase 121, 122, 123 à une phase de la machine électrique. Pour ce faire, le connecteur de phase 111, 112, 113 est monté sur le port de phase 121, 122, 123 correspondant par l'intermédiaire d'un moyen de fixation. Dans l'exemple illustré à la figure 2, ce moyen de fixation se présente sous la forme d'une vis 130. Chaque connecteur de phase 111, 112, 113 traverse une ouverture du boitier 5 pour permettre de relier l'onduleur 1 à la machine électrique et notamment permettre la circulation des courants alternatifs entre le module électronique de puissance 10 et la machine électrique.

L'unité électronique de contrôle 20 comprend des composants pour contrôler les composants du module électronique de puissance 10. Plus précisément, l'unité électronique de contrôle 20 commande le module électronique de puissance 10 afin qu'il réalise la fonction de conversion du courant continu reçu de la batterie haute tension, définissant une tension continue entre la barre 30 de connexion électrique positive et la barre de connexion électrique 40 négative, en trois courants de phase alternatifs de commande du moteur (ou vice-versa).

A cette fin, l'unité électronique de contrôle 20 se présente sous la forme d'une carte électronique 200 comportant notamment un premier ensemble de pistes électriques (non représenté par souci de clarté), appelé bus continu, et un deuxième ensemble de pistes électriques, appelé bus alternatif (non représenté par souci de clarté). Le bus continu est relié à la barre 30 de connexion électrique positive et à la barre 40 de connexion électrique négative entre lesquelles circule le courant continu délivré par la batterie d'alimentation haute tension. Le bus alternatif est relié aux connecteurs de phase 111, 112, 113 du module électronique de puissance 10.

La carte électronique 200 peut être montée sur une paroi (latérale 5-1 ou inférieure) du boitier 5 ou un élément de support (non représenté, qui peut par exemple être une plaque) suspendu dans le logement défini par le boitier 5. En particulier, le module électronique de puissance 10, l'élément de support et l'unité électronique de contrôle 20 peuvent être superposés l'un en vis-à-vis de l'autre dans le logement défini par le boitier 5, l'élément de support se trouvant alors entre le module électronique de puissance 10 et l'unité électronique de contrôle 20. Par exemple, un tel élément de support peut être rapporté dans le boitier 5 et maintenu en place en venant en appui contre des portions de matière dudit boitier 5, notamment des excroissances issues de la surface du boitier 5. Le support peut notamment être maintenu en place en venant en appui au niveau de sa périphérie. Cet élément de support peut par exemple être en métal pour améliorer la dissipation thermique de l'unité électronique de contrôle 20.

La carte électronique 200 de l'unité électronique de contrôle 20 contrôle les composants, notamment les interrupteurs, du module électronique de puissance 10. A cet effet, l'unité électronique de contrôle 20 peut être configurée pour échanger, via les connecteurs de signaux 5-31, 5-32 des signaux de données avec l'extérieur de l'onduleur 1, par exemple avec un contrôleur du véhicule.

Afin de pouvoir mesurer l'intensité ou les variations d'intensité des courants circulant dans la borne électrique externe positive 124, la barre 30 de connexion électrique positive est reliée électriquement à la carte électronique 200 par l'intermédiaire de broches 310 de connexion électrique comme cela sera décrit ci-après.

L'unité électronique de contrôle 20 comprend un ou plusieurs capteurs de courant (non représentés) permettant, via la barre 30 de connexion électrique positive, de mesurer l'intensité ou les variations des courants circulant dans la borne électrique externe positive 124. De tels capteurs de courant peuvent notamment être montés en surface de la carte électronique 200 de l'unité électronique de contrôle 20. Notamment, chaque capteur de courant peut mesurer le courant à partir d'un champ magnétique induit par le passage du courant. Les capteurs de courants sont par exemple des capteurs à effet Hall. Chaque capteur de courant peut comprendre des broches qui sont reçues dans la carte électronique 200 de l'unité électronique de contrôle 20 pour y acheminer la valeur du courant mesuré.

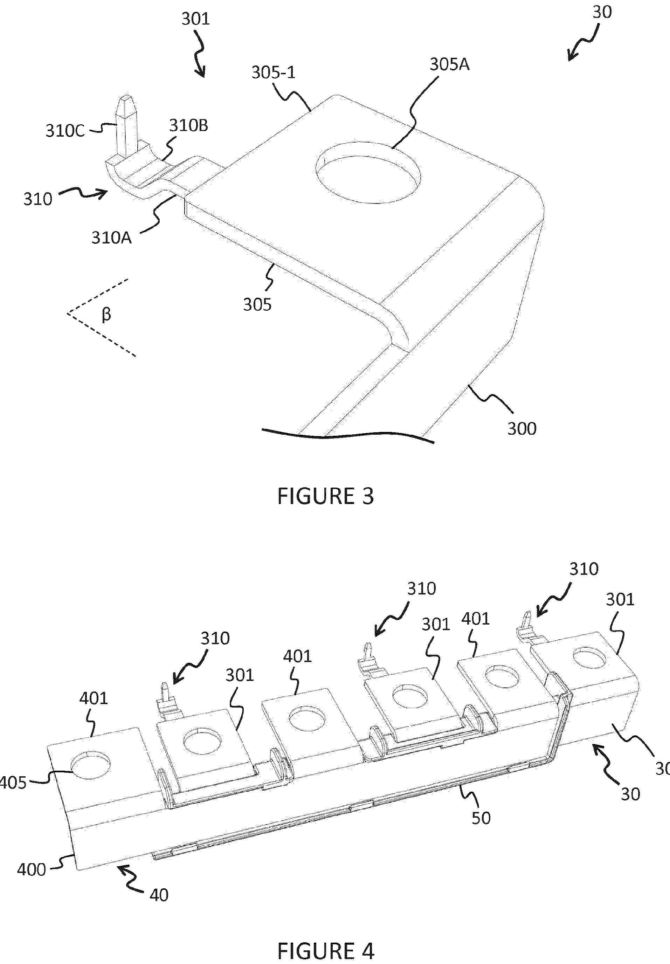

Dans l'exemple préféré illustré aux figures 3 à 5, la barre 30 de connexion électrique positive est une pièce monobloc métallique, c'est-à-dire réalisée d'un seul tenant, qui peut ainsi avantageusement être formée en la conformant à partir d'un même matériau, notamment d'une seule lame ou plaque métallique. La barre 30 de connexion électrique positive peut par exemple être réalisée en cuivre, en acier, en aluminium ou tout autre matériau conducteur. La barre 30 peut en outre avantageusement être recouverte d'une surface anticorrosion, par exemple composée d'étain et de nickel.

La barre 30 de connexion électrique positive comprend une embase 300 et trois éléments de connexion 301. L'embase 300 se présente sous la forme d'une plaque plane rectangulaire allongée.

Chaque élément de connexion 301 s'étend depuis l'embase 300 et comprend une portion 305 de fixation, plane, et une broche 310 de connexion électrique. La portion 305 de fixation s'étend orthogonalement à l'embase 300 et est électriquement conductrice. La portion 305 de fixation est destinée à être reliée électriquement à la borne électrique externe positive 124. De manière avantageuse, l'épaisseur de la portion 305 de fixation est inférieure à 1,5 mm, de préférence de l'ordre de 1 mm, afin de rendre aisée la formation de la broche 310 de connexion électrique lors de la fabrication de la barre 30 de connexion électrique positive.

La broche 310 de connexion électrique s'étend depuis le bord 305-1 libre de la portion 305 de fixation, qui est opposé au bord de liaison de la portion 305 de fixation à l'embase 300. La broche 310 de connexion électrique comprend une extrémité de liaison 310A reliée à la portion 305 de fixation au niveau du bord 305-1, une portion intermédiaire 310B et une extrémité libre 310C reliée à ladite extrémité de liaison 310A par ladite portion intermédiaire 310B, ladite une extrémité libre 310C étant adaptée pour être connectée électriquement à l'unité électronique de contrôle 20, notamment à une piste électrique de la carte électronique 200.

La portion 305 de fixation, de forme rectangulaire, est adaptée pour venir en contact avec une portion plane de la borne électrique externe positive 124. Comme illustré sur la figure 3, la portion 305 de fixation s'étend selon un plan principal β. Un orifice 305A est formé dans la portion 305 de fixation afin de recevoir la tige d'une vis 131 de fixation (figure 6) permettant de solidariser la barre 30 de connexion électrique positive à la borne électrique externe positive 124 ou de recevoir un connecteur positif de batterie (non représenté).

L'extrémité de liaison 310A s'étend principalement dans un plan orthogonal au plan principal β. La portion intermédiaire 310B s'étend principalement dans un plan parallèle au plan principal β. La portion intermédiaire 310B est en partie courbée afin de relier l'extrémité de liaison 310A et l'extrémité libre 310C. L'extrémité libre 310C s'étend orthogonalement au plan principal β et présente une forme adaptée pour être logée dans un orifice de la carte électronique 200 afin d'y être soudée. Dans cet exemple non limitatif, l'extrémité distale de l'extrémité libre 310C est sensiblement pointue.

On notera que la broche 310 de connexion électrique pourrait comprendre plus d'une extrémité libre 31 0C, par exemple afin de conférer une fonction de blocage ou d'anti-rotation à la barre 30 dans le plan principal β lorsqu'elle est reliée à la carte électronique 200.

La forme des broches 310 de la barre 30 permet de déporter les extrémités libres 310C depuis leur portion 305 de fixation respective de manière à ce qu'elles s'étendent à distance de ladite portion 305 de fixation. En d'autre termes, pour chaque broche, la portion intermédiaire 310B permet de franchir une distance entre la portion 305 de fixation et l'extrémité libre 310C afin notamment de positionner ladite extrémité libre 310C au droit de la piste ou de la borne de connexion électrique de la carte électronique 200 au niveau de laquelle elle est destinée à être connectée électriquement, par exemple par soudage. Dans cet exemple les longueurs des portions 305 de fixation et/ou de broches 310 de connexion pourraient être différentes entre elles afin de permettre de relier la barre 30 de connexion électrique positive à différents points de la carte électronique 200.

Un tel agencement de la barre 30 de connexion électrique permet notamment d'améliorer l'intégration des composants dans le boitier 5 de l'onduleur 1 et de rendre le montage de la carte électronique 200 aisé tout en conférant un bon contact électrique entre les extrémités libres 310C et leur point de connexion électrique sur la carte électronique 200.

On notera que dans cet exemple préféré, l'extrémité libre 310C des broches 310 de connexion électrique s'étend parallèlement mais dans une direction opposée à l'embase 300 par rapport à la portion 305 de fixation. Toutefois, la forme des broches 310 de connexion électrique pourrait être inversée de sorte que l'extrémité libre 310C des broches 310 de connexion électrique s'étende parallèlement et dans la même direction que l'embase 300 par rapport à la portion 305 de fixation.

La barre 30 de connexion électrique positive permet de connecter électriquement le module électronique de puissance 10 au connecteur positif de la batterie d'alimentation haute tension. Afin de connecter le module électronique de puissance 10 au connecteur négatif de la batterie d'alimentation haute tension, l'onduleur 1 comprend une deuxième barre 40 de connexion électrique, appelée barre 40 de connexion électrique négative, qui est, dans cet exemple non limitatif, dépourvue de broches 310 de connexion à la carte électronique 200.

En référence aux figures 4 et 5, la barre 40 de connexion électrique négative comprend également une embase 400 et trois éléments de connexion se présentant sous la forme d'une plaque 401 plane s'étendant orthogonalement à l'embase 400. La portion 401 plane délimite un orifice 405 de réception d'une vis 131 ou du connecteur négatif de la batterie d'alimentation haute tension.

La barre 30 de connexion électrique positive et la barre 40 de connexion électrique négative sont montées sur un séparateur 50, non conducteur électriquement, réalisé par exemple en matériau plastique (merci de confirmer), afin d'empêcher les courts-circuits entre la barre 30 de connexion électrique positive et la barre 40 de connexion électrique négative.

Dans l'exemple de la figure 2, le barre 30 de connexion électrique positive et la barre 40 de connexion électrique négative comprennent en outre chacun un organe de réception d'une composant électronique, ici une résistance de décharge 70, se présentant sous la forme d'une paire de clips d'attache 60. Une telle résistance de décharge 70 permet de libérer l'énergie dans l'onduleur 1 par effet joule afin d'éviter les électrisations ou électrocutions, notamment en cas d'urgence (par exemple en cas d'accident du véhicule ou d'ouverture du produit sous tension). On notera que seule une résistance de décharge 70 a été représentée sur la figure 2 pour des raisons de clarté alors que l'onduleur 1 en comprend deux sur la figure 6. De même, on notera que les clips d'attache 60 et la ou les résistances de décharge 70 n'ont pas été représentés sur les figures 3, 4, 5 et 7 pour des raisons évidentes de clarté.

Un exemple de montage de l'onduleur 1 va maintenant être décrit, notamment en référence aux figures 4 à 8.

La barre 30 de connexion électrique positive et la barre 40 de connexion électrique négative sont tout d'abord montées sur un séparateur 50 comme illustré aux figures 4 et 5. L'ensemble ainsi formé est ensuite monté sur le module électronique de puissance 10 de sorte que la barre 30 de connexion électrique positive vienne en contact sur la borne électrique externe positive 124 et que la barre 40 de connexion électrique négative vienne en contact sur la borne électrique externe négative 125.

En variante, la barre 30 de connexion électrique positive peut tout d'abord être montée sur le module électronique de puissance 10 puis le séparateur 50 peut être monté sur la barre 30 de connexion électrique positive puis la barre 40 de connexion électrique négative peut être montée sur le séparateur 50.

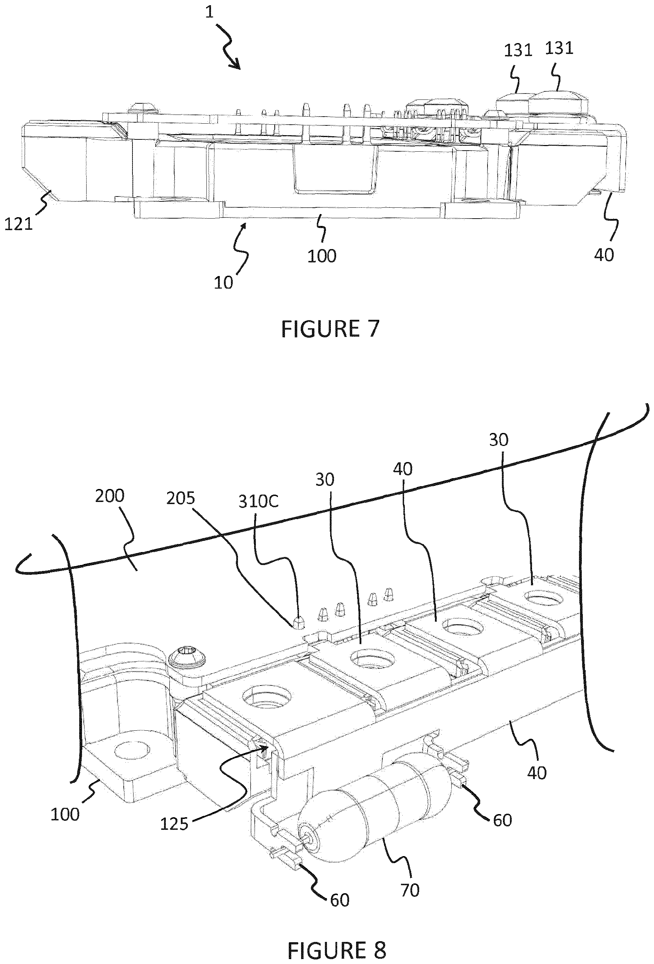

La carte électronique 200 est ensuite positionnée sur le module électronique de puissance 10 de sorte que les extrémités libres 310C des broches 310 de connexion de la barre 30 de connexion électrique positive soient insérées dans des orifices 205 correspondant de la carte électronique 200 (figure 8). Les extrémités libres 310C des broches 310 de connexion sont alors soudées sur la carte électronique 200.

Quatre vis 131 sont utilisées pour fixer la barre 30 de connexion électrique positive et la barre 40 de connexion électrique négative respectivement sur la borne électrique externe positive 124 et sur la borne électrique externe négative 125. Chaque vis 130 comprend un filetage qui correspond avec un taraudage de la borne électrique externe 124, 125 correspondante afin de fixer solidement la barre 30 de connexion électrique positive et la barre 40 de connexion électrique négative.

Les orifices 305A, 405 des éléments de connexion 301, 401 centraux respectivement de la barre 30 de connexion électrique positive et de la barre 40 de connexion électrique négative sont laissés libres pour permettre de connecter ultérieurement les connecteurs positif et négatif de la batterie d'alimentation haute tension.

Les connecteurs de phases 111, 112, 113 sont montés par ailleurs sur les connecteurs de phase 111, 112, 113 correspondant. Des vis 130 sont alors utilisées pour solidariser chaque connecteur de phase 111, 112, 113 avec le port de phase 121, 122, 123 correspondant.

Dans l'exemple préféré décrit ci-avant, la barre 40 de connexion électrique négative, qui est dépourvue de broches de connexion 310, est reliée au potentiel négatif de la batterie d'alimentation haute tension et la barre 30 de connexion électrique positive, qui comporte des broches de connexion 310, est reliée au potentiel positif de la batterie d'alimentation haute tension afin de mesurer l'intensité ou les variations d'intensité du courant dans la borne électrique externe positive 124 du module électronique de puissance 10.

On notera qu'en variante, la barre 30 de connexion électrique pourrait être reliée au potentiel négatif de la batterie d'alimentation haute tension et la barre 40 de connexion électrique pourrait être reliée au potentiel positif de la batterie d'alimentation haute tension, une telle configuration permettant alors de mesurer l'intensité ou les variations d'intensité du courant dans la borne électrique externe négative du module électronique de puissance 10.

On notera aussi que, dans une autre variante, la barre 30 de connexion électrique positive et la barre 40 de connexion électrique négative pourraient toutes deux comprendre une ou plusieurs broches de connexion 310 afin de mesurer l'intensité ou les variations d'intensité du courant à la fois dans la borne électrique externe négative et dans la borne électrique externe positive 124 du module électronique de puissance 10.

## Revendications

1. Barre (30) de connexion électrique pour un ensemble (1) électrique, ledit ensemble (1) comprenant un module électronique de puissance (10) et une unité électronique de contrôle (20) dudit module électronique de puissance (10), ledit module électronique de puissance (10) comportant au moins une borne électrique externe (124), ladite barre (30) étant **caractérisée en ce qu'**elle est destinée à relier électriquement ladite au moins une borne électrique externe (124) à l'unité électronique de contrôle (20) et **en ce qu'**elle comprend :
- une embase (300) plane, et
- au moins un élément de connexion (301) s'étendant depuis ladite embase (300) et comprenant :
• au moins une portion (305) de fixation conductrice électriquement, s'étendant orthogonalement à l'embase (300) et destinée à être reliée électriquement avec la au moins une borne électrique externe (124), et
• au moins une broche (310) de connexion électrique s'étendant depuis un bord (305-1) de la portion (305) de fixation et comprenant une extrémité de liaison (310A) reliée à la portion (305) de fixation, au moins une portion intermédiaire (310B) et au moins une extrémité libre (310C) reliée à ladite extrémité de liaison (310A) par ladite au moins une portion intermédiaire (31 0B), ladite au moins une extrémité libre (31 0C) étant adaptée pour être connectée électriquement à l'unité électronique de contrôle (20).

2. Barre (30) de connexion électrique selon la revendication 1, dans laquelle la au moins une portion (305) de fixation et la au moins une broche (310) de connexion électrique sont issues de même matière.

3. Barre (30) de connexion électrique selon l'une des revendications précédentes, dans laquelle l'embase (300) et le au moins un élément de connexion (301) sont issus de même matière.

4. Barre (30) de connexion électrique selon l'une des revendications précédentes, ladite barre (30) de connexion électrique étant une pièce monobloc.

5. Barre (30) de connexion électrique selon l'une des revendications précédentes, ladite barre (30) de connexion électrique étant métallique.

6. Barre (30) de connexion électrique selon l'une des revendications précédentes, dans laquelle la portion (305) de fixation délimite un orifice (305A) apte à recevoir un organe (131) de fixation de la barre (30) de connexion électrique sur la au moins une borne électrique externe (124) du module électronique de puissance (10).

7. Barre (30) de connexion électrique selon l'une des revendications précédentes, dans laquelle ladite au moins une extrémité libre (310C) s'étend orthogonalement au plan (β) de la portion (305) de fixation.

8. Barre (30) de connexion électrique selon l'une des revendications précédentes, comprenant en outre au moins un organe de réception (60) d'une résistance de décharge (70).

9. Barre (30) de connexion électrique selon la revendication précédente, dans laquelle le au moins un organe de réception comprend deux clips d'attache (60) adaptés pour recevoir chacun une branche de ladite résistance de décharge (70).

10. Ensemble (1) électrique comprenant un module électronique de puissance (10) et une unité électronique de contrôle (20), ledit module électronique de puissance (10) comportant au moins une borne électrique externe (124), l'ensemble (1) électrique étant **caractérisé en ce qu'**il comprend au moins une barre (30) de connexion électrique, selon l'une des revendications précédentes, fixée sur ladite au moins une borne électrique externe (124) et reliée électriquement à l'unité électronique de contrôle (20).

11. Ensemble (1) selon la revendication précédente, dans lequel la au moins une barre (30) de connexion électrique est montée sur la au moins une borne électrique externe (124) par l'intermédiaire d'au moins un organe (131) de fixation traversant un orifice (305A) formé dans la portion (305) de fixation du au moins un élément de connexion (301) de manière à relier électriquement la au moins une barre (30) de connexion et la borne électrique externe (124) du module électronique de puissance (10).

12. Ensemble (1) électrique selon l'une des revendications 10 et 11, dans lequel la au moins une borne électrique externe (124) et la portion (305) de fixation du au moins un élément de connexion (301) sont superposées et en contact.

## Patentansprüche

1. Elektrische Anschlussleiste (30) für eine elektrische Anordnung (1), wobei die Anordnung (1) ein elektronisches Leistungsmodul (10) und eine elektronische Steuereinheit (20) des elektronischen Leistungsmoduls (10) umfasst, wobei das elektronische Leistungsmodul (10) mindestens einen externen elektrischen Anschluss (124) umfasst, wobei die Leiste (30) **dadurch gekennzeichnet ist, dass** sie dazu bestimmt ist, den mindestens einen externen elektrischen Anschluss (124) mit der elektronischen Steuereinheit (20) elektrisch zu verbinden, und dadurch, dass sie Folgendes umfasst:
- einen ebenen Sockel (300) und
- mindestens ein Anschlusselement (301), das sich von dem Sockel (300) aus erstreckt und Folgendes umfasst:
• mindestens einen elektrisch leitenden Befestigungsabschnitt (305), der sich orthogonal zum Sockel (300) erstreckt und dazu bestimmt ist, elektrisch mit dem mindestens einen externen elektrischen Anschluss (124) verbunden zu werden, und
• mindestens einen elektrischen Anschlussstift (310), der sich von einem Rand (305-1) des Befestigungsabschnitts (305) erstreckt und ein mit dem Befestigungsabschnitt (305) verbundenes Verbindungsende (310A), mindestens einen Zwischenabschnitt (310B) und mindestens ein freies Ende (310C) umfasst, das über den mindestens einen Zwischenabschnitt (310B) mit dem Verbindungsende (310A) verbunden ist, wobei das mindestens eine freie Ende (310C) so beschaffen ist, dass es elektrisch mit der elektronischen Steuereinheit (20) verbunden werden kann.

2. Elektrische Anschlussleiste (30) nach Anspruch 1, wobei der mindestens eine Befestigungsabschnitt (305) und der mindestens eine elektrische Anschlussstift (310) aus demselben Material bestehen.

3. Elektrische Anschlussleiste (30) nach einem der vorhergehenden Ansprüche, wobei der Sockel (300) und das mindestens eine Anschlusselement (301) aus demselben Material bestehen.

4. Elektrische Anschlussleiste (30) nach einem der vorhergehenden Ansprüche, wobei die elektrische Anschlussleiste (30) ein einstückiges Teil ist.

5. Elektrische Anschlussleiste (30) nach einem der vorhergehenden Ansprüche, wobei die elektrische Anschlussleiste (30) aus Metall besteht.

6. Elektrische Anschlussleiste (30) nach einem der vorhergehenden Ansprüche, wobei der Befestigungsabschnitt (305) eine Öffnung (305A) abgrenzt, die geeignet ist, ein Organ (131) zur Befestigung der elektrischen Anschlussleiste (30) an dem mindestens einen externen elektrischen Anschluss (124) des elektronischen Leistungsmoduls (10) aufzunehmen.

7. Elektrische Anschlussleiste (30) nach einem der vorhergehenden Ansprüche, wobei sich das mindestens eine freie Ende (310C) orthogonal zur Ebene (β) des Befestigungsabschnitts (305) erstreckt.

8. Elektrische Anschlussleiste (30) nach einem der vorhergehenden Ansprüche, die außerdem mindestens ein Aufnahmeorgan (60) für einen Entladungswiderstand (70) umfasst.

9. Elektrische Anschlussleiste (30) nach dem vorhergehenden Anspruch, wobei das mindestens eine Aufnahmeorgan zwei Befestigungsclips (60) umfasst, die jeweils zur Aufnahme eines Anschlussdrahts des Entladungswiderstand (70) geeignet sind.

10. Elektrische Anordnung (1), die ein elektronisches Leistungsmodul (10) und eine elektronische Steuereinheit (20) umfasst, wobei das elektronische Leistungsmodul (10) mindestens einen externen elektrischen Anschluss (124) aufweist, wobei die elektrische Anordnung (1) **dadurch gekennzeichnet ist, dass** sie mindestens eine elektrische Anschlussleiste (30) nach einem der vorhergehenden Ansprüche umfasst, die an dem mindestens einen externen elektrischen Anschluss (124) befestigt ist und elektrisch mit der elektronischen Steuereinheit (20) verbunden ist.

11. Anordnung (1) nach dem vorhergehenden Anspruch, wobei die mindestens eine elektrische Anschlussleiste (30) an dem mindestens einen externen elektrischen Anschluss (124) über mindestens ein Befestigungsorgan (131) angebracht ist, das durch eine Öffnung (305A) hindurchgeht, die in dem Befestigungsabschnitt (305) des mindestens einen Anschlusselements (301) ausgebildet ist, um die mindestens eine Anschlussleiste (30) und den externen elektrischen Anschluss (124) des elektronischen Leistungsmoduls (10) elektrisch zu verbinden.

12. Elektrische Anordnung (1) nach einem der Ansprüche 10 und 11, wobei der mindestens eine externe elektrische Anschluss (124) und der Befestigungsabschnitt (305) des mindestens einen Anschlusselements (301) übereinander liegen und sich berühren.

## Claims

1. Electrical busbar (30) for an electrical assembly (1), said assembly (1) comprising an electronic power module (10) and an electronic control unit (20) for controlling said electronic power module (10), said electronic power module (10) comprising at least one external electrical terminal (124), said busbar (30) being **characterized in that** it is intended to electrically connect said at least one external electrical terminal (124) to the electronic control unit (20) and **in that** it comprises:
- a flat base (300), and
- at least one connection element (301) extending from said base (300) and comprising:
• at least one electrically conductive fastening portion (305), extending orthogonally to the base (300) and intended to be electrically connected with the at least one external electrical terminal (124), and
• at least one electrical connection pin (310) extending from an edge (305-1) of the fastening portion (305) and comprising a linking end (310A) connected to the fastening portion (305), at least one intermediate portion (310B) and at least one free end (310C) connected to said linking end (310A) by said at least one intermediate portion (310B), said at least one free end (310C) being suitable for being electrically connected to the electronic control unit (20).

2. Electrical busbar (30) according to Claim 1, wherein the at least one fastening portion (305) and the at least one electrical connection pin (310) are made from the same material.

3. Electrical busbar (30) according to one of the preceding claims, wherein the base (300) and the at least one connection element (301) are made from the same material.

4. Electrical busbar (30) according to one of the preceding claims, said busbar (30) being a monobloc part.

5. Electrical busbar (30) according to one of the preceding claims, said busbar (30) being metallic.

6. Electrical busbar (30) according to one of the preceding claims, wherein the fastening portion (305) delimits an orifice (305A) which is able to receive a member (131) for fastening the electrical busbar (30) to the at least one external electrical terminal (124) of the electronic power module (10).

7. Electrical busbar (30) according to one of the preceding claims, wherein said at least one free end (310C) extends orthogonally to the plane (β) of the fastening portion (305).

8. Electrical busbar (30) according to one of the preceding claims, further comprising at least one receiving member (60) for receiving a discharge resistor (70) .

9. Electrical busbar (30) according to the preceding claim, wherein the at least one receiving member comprises two attaching clips (60) suitable for each receiving a branch of said discharge resistor (70).

10. Electrical assembly (1) comprising an electronic power module (10) and an electronic control unit (20), said electronic power module (10) comprising at least one external electrical terminal (124), the electrical assembly (1) being **characterized in that** it comprises at least one electrical busbar (30), according to one of the preceding claims, fastened to said at least one external electrical terminal (124) and electrically connected to the electronic control unit (20).

11. Assembly (1) according to the preceding claim, wherein the at least one electrical busbar (30) is mounted on the at least one external electrical terminal (124) by means of at least one fastening member (131) passing through an orifice (305A) formed in the portion (305) for fastening the at least one connection element (301) so as to electrically connect the at least one busbar (30) and the external electrical terminal (124) of the electronic power module (10).

12. Electrical assembly (1) according to one of Claims 10 and 11, wherein the at least one external electrical terminal (124) and the portion (305) for fastening the at least one connection element (301) are superposed and in contact.
